# EUROPEAN PATENT SPECIFICATION

(11) **EP 2 733 177 B1**
(45) Date of publication and mention of the grant of the patent: **30.08.2017**
(21) Application number: 12811367.7
(22) Date of filing: 03.07.2012
(51) Int. Cl.: C08L 63/00, C08G 59/40, C08J 5/24, C08K 3/00, C08K 5/3415, C08L 65/00, H05K 1/03

(54) **RESIN COMPOSITION FOR PRINTED WIRING BOARDS**
HARZZUSAMMENSETZUNG FÜR LEITERPLATTEN
COMPOSITION À BASE DE RÉSINE POUR PLAQUETTES DE CIRCUITS IMPRIMÉS

(30) Priority: 14.07.2011 JP 2011155983
(43) Date of publication of application: 21.05.2014
(73) Proprietor: Mitsubishi Gas Chemical Company, Inc., Tokyo 100-8324 (JP)
(72) Inventor: KASHIMA, Naoki, Tokyo 125-8601 (JP); HASEBE, Keiichi, Tokyo 125-8601 (JP); SHIKA, Seiji, Tokyo 125-8601 (JP); MABUCHI, Yoshinori, Tokyo 125-8601 (JP); KATO, Yoshihiro, Tokyo 125-8601 (JP)
(74) Representative: Hoffmann Eitle
(86) International application number: PCT/JP2012/066995
(87) International publication number: WO 2013/008684

(56) References cited:
- EP-A1- 1 961 554
- EP-A1- 2 090 612
- WO-A1-2008/126411
- WO-A1-2010/050472
- JP-A- 2001 294 689
- JP-A- 2002 194 119
- JP-A- 2003 298 243
- JP-A- 2004 182 850
- JP-A- 2005 005 458
- JP-A- 2007 045 984
- JP-A- 2007 138 075
- JP-A- 2009 242 449
- JP-A- 2010 031 263
- JP-A- 2011 052 188
- US-A1- 2011 007 489

## Description

### TECHNICAL FIELD

The present invention relates to a resin composition that is useful in the case of using in an insulated layer in a printed wiring board material.

### BACKGROUND ART

Accompanying the reduced size and higher performance of electronic devices in recent years, multilayer printed wiring boards are being provided with increasingly hyperfine conductor wiring in order to improve the mounting density of electronic components, thereby creating a desire for technology capable of forming that wiring. Known examples of methods used to form high-density, hyperfine wiring on an insulated layer include additive methods, by which a conductor layer is formed by non-electrolytic plating only, and semi-additive methods, by which a conductor layer is formed by electrolytic plating after having formed a thin copper layer over the entire surface by non-electrolytic plating, followed by flash etching a thin copper layer.

In general, in the case of forming through holes or blind vias required for interlayer connection of printed wiring boards by laser processing, desmear treatment is carried out in which a neutralization step is carried out with a reductant after having gone through wet treatment with a swelling agent and alkaline permanganate solution or other oxidant in order to remove smears occurring at that time. In addition to carrying out for the purpose of removing smears, desmear treatment is also used in semi-additive methods in order to ensure adhesive strength with the conductor layer formed thereon by forming a comparatively large physical anchor on the insulated layer surface by wet treatment.

The roughness of the insulated layer surface is preferably as low as possible since excessive roughness prevents the plating of deep portions of physical anchors from being completely removed during flash etching processing of the subsequent step. On the other hand, adhesive strength between the conductor layer and insulated layer tends to become small if the roughness of the insulated layer surface is excessively low. Accordingly, an insulated layer resin composition is required to demonstrate high interfacial adhesive strength with the conductor layer even if roughness of the insulated layer surface is low.

As a means of solving this problem, a technology is known that uses as components of an insulated layer resin composition a rubber component and/or filler that decompose, come off or dissolve in an oxidant in the form of an alkaline permanganate solution used during desmear treatment (see Patent Documents 1 to 3). Fine surface irregularities are disclosed as being formed in the insulated layer surface as a result of this rubber component and/or filler decomposing, coming off or dissolving during desmear treatment, thereby resulting in high adhesive strength between the conductor layer and insulated layer.

However, it has not been possible to realize both insulated layer surface roughness and plated copper adhesiveness even in the case of these resin compositions.

### [Prior Art Documents]

### [Patent Documents]

Patent Document 1: Japanese Unexamined Patent Publication No. 2007-294487
Patent Document 2: Japanese Unexamined Patent Publication No. H09-148748
Patent Document 3: Japanese Unexamined Patent Publication No. 2007-254709

EP1961554 and US2011/007489 disclose epoxy resin compositions for prepreg.

### DISCLOSURE OF THE INVENTION

### [Problems to be Solved by the Invention]

An object of the present invention is to provide a resin composition that allows the formation of a roughened surface having a low degree of roughness on an insulated layer surface in the case of using in an insulated layer in a printed wiring board material, and demonstrates superior adhesiveness, moisture absorption heat resistance and low-temperature expansion of a conductor layer formed on the roughened surface, as well as a prepreg, resin sheet, metal foil-clad laminate sheet and printed wiring board using that resin composition.

### [Means for Solving the Problems]

As a result of conducting extensive studies, the inventors of the present invention found that the aforementioned problems are solved by using a resin composition comprising: (A) an acid-soluble inorganic filler which is magnesium oxide having an average particle diameter of between 0.1 and 1.0 µm, (B) a cyanate ester compound, (C) an epoxy resin and (D) a bismaleimide, thereby leading to completion of the present invention. Although the reason for this is unclear, it is presumed to be as follows. Namely, it is presumed that, in addition to the acid-soluble inorganic filler dissolving in an acidic reductant but not dissolving in an alkaline oxidant used in a desmear treatment step, as a result of the cyanate ester compound (B) having high chemical resistance, the acid-soluble inorganic filler
(A) only comes off in a neutralization step employing the acidic reductant without coming off in a roughening step using the alkaline oxidant during desmear treatment, thereby enabling surface irregularities formed on an insulated layer surface to demonstrate anchoring effects during formation of a conductor layer.

### [Effects of the Invention]

The resin composition of the present invention at least demonstrates any of the following effects in the case of using in an insulated layer in a printed board wiring material:
(1) formation of a roughened surface having a low degree of roughness on an insulated layer surface;
(2) superior adhesiveness to a conductor layer formed on the roughened surface; and,
(3) superior moisture absorption heat resistance.

In addition, a printed wiring board having the aforementioned effects is obtained by a prepreg, metal foil-clad laminate sheet and resin sheet of the present invention having an insulated layer containing the resin composition of the present invention.

### DESCRIPTION OF EMBODIMENTS

### [Resin Composition]

According to one aspect of the present invention, a resin composition is provided comprising: (A) an acid-soluble inorganic filler, (B) a cyanate ester, (C) an epoxy resin and (D) a bismaleimide. This resin composition may further contain (E) silica.

The acid-soluble inorganic filler (A) used in the present invention is magnesium oxide. Here, "acid-soluble" refers to demonstrating solubility with respect to an acidic
reductant used to neutralize the alkaline oxidant during desmear treatment. More specifically, "acid-soluble" refers to normally demonstrating solubility of 5 g/L to 30 g/L, and preferably 10 g/L to 25 g/L, with respect to a neutralizing treatment solution manufactured by Okuno Chemical Industries (200 ml/L OPC-1300 Neutralizer (sulfuric acid: 1 ml/L)).

The acid-soluble inorganic filler (A) is magnesium oxide (MgO). This compound elutes into neutralizing solution during desmear treatment of an insulated layer surface to form a uniform roughened layer, demonstrates anchoring effects, and improves plating peel strength.

More specifically, examples of magnesium oxide include FNM-G manufactured by Tateho Chemical Industries Co., Ltd., and SMO, SMO-0.1 and SMO-0.5 manufactured by Sakai Chemical Industry Co., Ltd. Furthermore, one type of the acid-soluble inorganic
filler (A) may be used alone or two or more types may be used concurrently in an arbitrary combination and ratio.

The average particle diameter of the aforementioned acid-soluble inorganic filler (A) is within the range of 0.1 µm to 1 µm. Here, average particle diameter refers to the median diameter. Median diameter refers to, in the case of dividing the particle size distribution of a measurement target powder into two groups bordering on a certain particle diameter, the particle diameter such that the number or total weight of the particles in the group having the large particle diameter and the number or total weight of particles in the group having the small particle diameter respectively account for 50% of the particles or total weight of the entire powder. Median diameter is typically measured by wet laser diffraction scattering.

The content of the aforementioned acid-soluble inorganic filler (A) in the resin composition of the present invention is normally preferably within the range of 5 parts by weight to 150 parts by weight, particularly preferably within the range of 30 parts by weight to 120 parts by weight, and more preferably within the range of 40 parts by weight to 80 parts by weight based on value of 100 parts by weight for the total amount of components (B) and (C) from the viewpoint of the degree of roughness of the insulated layer surface. In the case a component (D) to be subsequently described is present in the resin composition of the present invention, the amount of the inorganic filler (A) is normally preferably within the range of 5 parts by weight to 100 parts by weight, particularly preferably within the range of 10 parts by weight to 100 parts by weight, and more preferably within the range of 20 parts by weight to 100 parts by weight based on a value of 100 parts by weight for the total amount of components (B) to (D).

In addition, the aforementioned acid-soluble inorganic filler (A) is preferably subjected to surface treatment from the viewpoints of moisture absorption heat resistance and chemical resistance. More specifically, the acid-soluble inorganic filler (A) is preferably subjected to silane coupling treatment with a silane coupling agent.

There are no particular limitations on the aforementioned silane coupling agent provided it is a silane coupling agent typically used in surface treatment of inorganic materials. Specific examples thereof include aminosilane-based coupling agents such as γ-aminopropyltriethoxysilane or N-β-(aminoethyl)-γ-aminopropyltrimethoxysilane, epoxy silane-based coupling agents such as γ-glycidoxypropyltrimethoxysilane, alkoxy-based coupling agents such as hexyltrimethoxysilane, vinyl silane-based coupling agents such as γ-methacryloxypropyltrimethoxysilane, cationic silane-based coupling agents such as N-β-(N-vinylbenzylaminoethyl)-γ-aminopropyltrimethoxysilane hydrochloride and phenyl silane-based coupling agents, with γ-glycidoxypropyltrimethoxysilane and hexyltrimethoxysilane being preferable. One type of silane coupling agent can be used alone or two or more types can be used in a suitable combination. In the case of using a silane coupling agent, although varying according to the respective types of inorganic filler and silane coupling agent used, the amount thereof used is normally preferably within the range of 0.05 parts by weight to 5 parts by weight and particularly preferably within the range of 0.1 parts by weight to 3 parts by weight based on a value of 100 parts by weight for the amount of acid-soluble inorganic filler.

In addition, in the case of treating the aforementioned acid-soluble inorganic filler with a silane coupling agent, the silane coupling agent is preferably used in combination with a dispersing agent. There are no particular limitations on the dispersing agent provided it is a dispersion stabilizer used for coating materials. Examples thereof include dispersing agents such as Disperbyk-110, 180, 161, BYK-W996, W9010 and W903 manufactured by Byk Chemie Japan K.K. In the case of using a dispersing agent, although varying according to the respective type of inorganic filler and dispersing agent, the amount used is normally preferably within the range of 0.1 part by weight to 5 parts by weight and particularly preferably within the range of 0.5 parts by weight to 3 parts by weight based on a value of 100 parts by weight for the amount of the acid-soluble inorganic filler.

The cyanate ester compound (B) used in the present invention has superior properties such as chemical resistance and adhesion, and can be preferably used as a component of the resin composition of the present invention since it allows the formation of a uniform roughened surface on the insulated layer surface when the acid-soluble inorganic filler (A) is eluted by desmear treatment due to the superior chemical resistance thereof.

A commonly known cyanate ester compound can be used for the cyanate ester compound (B) provided it has two or more cyanato groups (cyanate ester groups) in a molecule thereof. Examples thereof include naphthol aralkyl-type cyanic ester compounds, novolac-type cyanate esters, biphenyl aralkyl-type cyanate esters, 1,3-dicyanatobenzene, 1,4-dicyanatobenzene, 1,3,5-tricyanatobenzene, bis(3,5-dimethyl-4-cyanatophenyl)methane, 1,3-dicyanatonaphthalene, 1,4-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalene, 4,4'-dicyanatobiphenyl, bis(4-cyanatophenyl)methane, bis(4-cyanatophenyl)propane, bis(4-cyanatophenyl)ether, bis(4-cyanatophenyl)thioether, bis(4-cyanatophenyl)sulfone and 2,2'-bis(4-cyanatophenyl)propane. One type of these cyanate ester compounds (B) may be used alone or two or more types may be used concurrently in a suitable combination and ratio.

Among these, a naphthol aralkyl-type cyanate ester compound represented by formula (1), a novolac-type cyanate ester compound represented by formula (2), and/or a biphenyl aralkyl-type cyanate ester compound represented by formula (3) are particularly preferable since they have superior incombustibility, high curability and a low coefficient of thermal expansion of cured products. 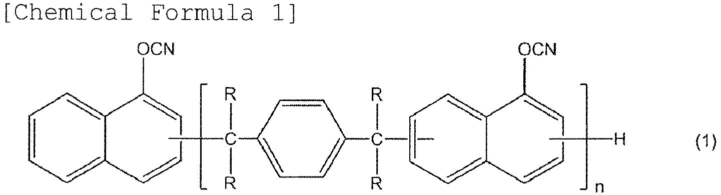 In the formula, R respectively and independently represents a hydrogen atom or methyl group, and preferably a hydrogen atom.

In the formula, n represents an integer equal to or greater than 1, and the upper limit of n is normally 10 and preferably 6.

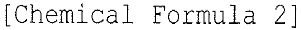

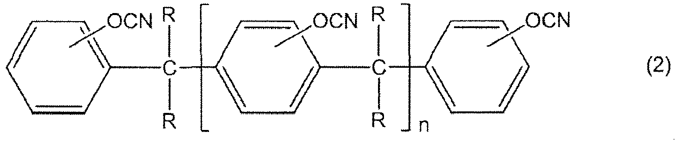

In the formula, R respectively and independently represents a hydrogen atom or methyl group, and preferably a hydrogen atom.

In the formula, n represents an integer equal to or greater than 0, and the upper limit of n is normally 10 and preferably 7.

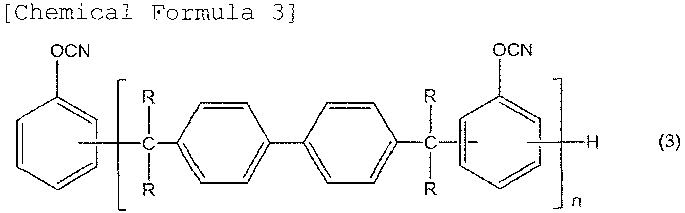

In the formula, R respectively and independently represents a hydrogen atom or methyl group, and preferably a hydrogen atom.

In the formula, n represents an integer equal to or greater than 1, and the upper limit of n is normally 10 and preferably 7.

Although there are no particular limitations thereon, the content of the cyanate ester compound (B) in the present invention is preferably within the range of 10 parts by weight to 90 parts by weight and particularly preferably within the range of 20 parts by weight to 70 parts by weight based on 100 parts by weight for the total amount of components (B) and (C) from the viewpoints of heat resistance and curability. In particular, in the case a component (D) to be subsequently described is present in the resin composition of the present invention, the amount of the cyanate ester compound (B) is normally within the range of 10 parts by weight to 90 parts by weight and preferably within the range of 20 parts by weight to 70 parts by weight based on a value of 100 parts by weight for the total amount of components (B) to (D).

There are no particular limitations on the epoxy resin (C) used in the present invention provided it has two or more epoxy groups in a molecule thereof. Examples thereof include phenol biphenyl aralkyl-type epoxy resins, bis-naphthalene tetrafunctional epoxy resins, aromatic hydrocarbon-formaldehyde-type epoxy resins (such as xylene-type epoxy resins), naphthol aralkyl-type epoxy resins, bisphenol A-type epoxy resins, bisphenol F-type epoxy resins, bisphenol A novolac-type epoxy resins, trifunctional phenol-type epoxy resins, tetrafunctional phenol-type epoxy resins, naphthalene-type epoxy resins, biphenyl-type epoxy resins, aralkyl novolac-type epoxy resins, alicyclic epoxy resins, polyol-type epoxy resins, compounds obtained by epoxidating double bonds such as glycidyl amines, glycidyl ethers or butadiene, and compounds obtained by a reaction between a hydroxide group-containing silicone resin and epichlorhydrin. Among these, phenol biphenyl aralkyl-type epoxy resins, naphthalene tetrafunctional epoxy resins, aromatic hydrocarbon-formaldehyde-type epoxy resins and naphthalene aralkyl-type epoxy resins are particularly preferable from the viewpoints of plated copper adhesion and incombustibility. One type of these epoxy resins (C) can be used alone or two or more types can be used by suitably mixing.

Examples of phenol biphenyl aralkyl-type epoxy resins include those having a structure represented by formula (4), examples of bis-naphthalene tetrafunctional epoxy resins include those having a structure represented by formula (5), examples of aromatic hydrocarbon-formaldehyde-type epoxy resins include those having a structure represented by formula (6), and examples of naphthol aralkyl-type epoxy resins include those having a structure represented by formula (7).

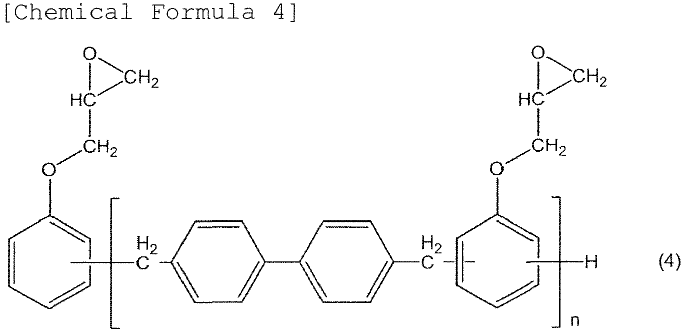

In the formula, n represents an integer equal to or greater than 1 and the upper limit of n is normally 10 and preferably 7.

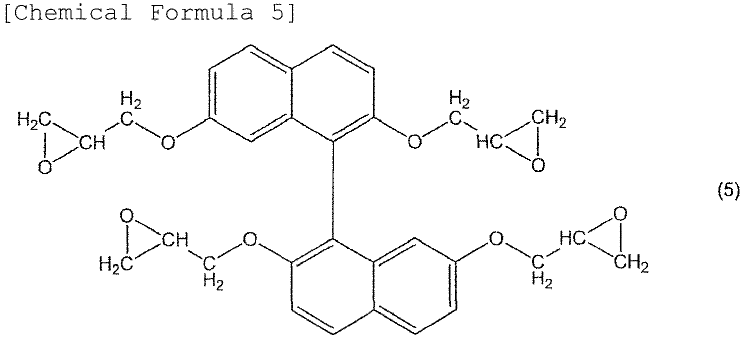

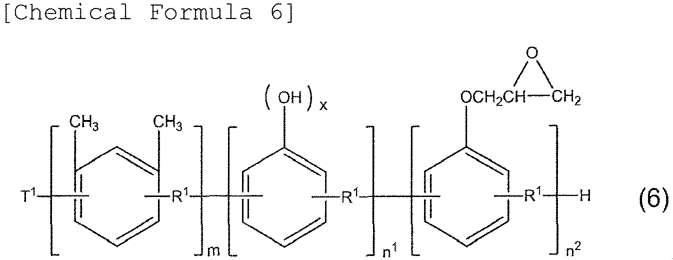

In the formula, R¹ respectively and independently represents a methylene group, methyleneoxy group, methyleneoxymethylene group or oxymethylene group.

In the formula, T¹ represents a hydrogen atom, hydroxyl group or hydroxymethylene group.

In the formula, x respectively and independently represents 0 or 1.

In the formula, m represents an integer equal to or greater than 1, and the upper limit of m is normally 50 or less and preferably 20 or less.

In the formula, n¹ represents an integer equal to or greater than 1, and the upper limit of n¹ is normally 20 or less.

In the formula, n² represents an integer equal to or greater than 1, and the upper limit of n² is normally 20 or less.

The weight average molecular weight of a compound represented by formula (6) is normally 250 to 5000 and preferably 300 to 3000.

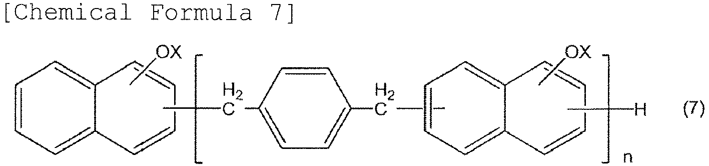

(In the formula, n represents a number of 1 to 6 as an average value thereof, X respectively and independently represents a glycidyl group or hydrocarbon group having 1 to 8 carbon atoms, and the molar ratio of the hydrocarbon group to the glycidyl group is 0.05 to 2.)

Although there are no particular limitations thereon, the content of the epoxy resin (C) in the present invention is normally preferably within the range of 10 parts by weight to 90 parts by weight, and particularly preferably within the range of 20 parts by weight to 70 parts by weight, based on a value of 100 parts by weight for the total amount of components (B) and (C) from the viewpoints of heat resistance and curability. In particular, in the case a component (D) to be subsequently described is present in the resin composition of the present invention, the amount of the epoxy resin (C) is normally preferably within the range of 10 parts by weight to 90 parts by weight and particularly preferably within the range of 20 parts by weight to 70 parts by weight based on a value of 100 parts by weight for the total amount of components (B) to (D).

The cyanate ester compound (B) and the epoxy resin (C) used in the present invention are preferably blended so that the usage ratio thereof is such that the ratio (CN/Ep) of the number of cyanate groups of the cyanate ester compound (B) in the resin composition (represented by CN) to the number of epoxy groups of the epoxy resin (C) (represented by Ep) is normally 0.3 to 3 and preferably 0.7 to 2.5. If the ratio of CN/Ep is within the aforementioned ranges, favorable incombustibility and curability can be obtained.

In the present invention, a bismaleimide (D) is used for the purpose of, for example, improving the moisture absorption heat resistance of a printed wiring board. There are no particular limitations on the bismaleimide (D) provided it is a compound having two or more maleimide groups in a molecule thereof, specific examples of which include bis(4-maleimidophenyl)methane, 2,2-bis{4-(4-maleimidophenoxy)-phenyl}propane, bis(3,5-dimethyl-4-maleimidophenyl)methane, bis(3-ethyl-5-methyl-4-maleimidophenyl)methane and bis(3,5-diethyl-4-maleimideophenyl)methane. In addition, the bismaleimide (D) can also be used in the form of prepolymers of these bismaleimides (such as compounds represented by the following formula (8)) as well as prepolymers of these bismaleimides and an amine compound. Among these, bis(3-ethyl-5-methyl-4-maleimidophenyl)methane (such as BMI-70 manufactured by K-I Chemical Industry Co., Ltd.) or a compound represented by the following formula (8) is particularly preferable from the viewpoints of moisture absorption heat resistance and incombustibility.

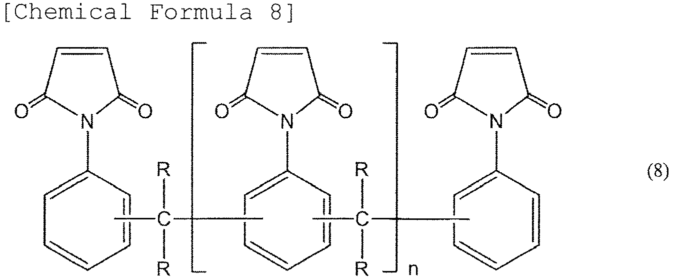

(In the formula, R respectively and independently represents a hydrogen atom or methyl group, and n represents an integer of 1 to 10 as the average value thereof.)

In particular, a compound represented by formula (8) demonstrates the effect of having numerous crosslinking sites enabling it to raise the glass transition temperature of a cured product as a result of having a novolac structure. Furthermore, a compound represented by formula (8) may be produced by various types of techniques known among persons with ordinary skill in the art, or a commercially available product may be used. An example of a commercially available product is BMI-2300 manufactured by Daiwa Kasei Industry Co., Ltd.

One type of these bismaleimides (D) can be used or two or more types can be used by suitably mixing.

In the case of using a bismaleimide (D), the content thereof is preferably 5 parts by weight to 50 parts by weight, and more preferably 10 parts by weight to 40 parts by weight, based on a value of 100 parts by weight for the total amount of components (B) to (D). If the content of the bismaleimide is within the aforementioned ranges, favorable moisture absorption heat resistance and incombustibility can be obtained.

In the present invention, silica (E) may be used in addition to the acid-soluble inorganic filler (A) for the purpose of, for example, lowering the incombustibility and thermal expansion of an insulated layer of a printed wiring board. Examples of the silica (E) include silica such as natural silica, fused silica, amorphous silica or hollow silica, short glass fibers and spherical glass (including fine glass powders such as E-glass, T-glass or D-glass). One type of this silica (E) can be used or two or more types can be used by suitably mixing. Among these, fused silica is preferable due to its superior reduction of thermal expansion.

Although there are no particular limitations on the average particle diameter of the aforementioned silica (E), the average particle diameter is preferably 0.2 µm to 5 µm in consideration of dispersibility.

In the case of using the aforementioned silica (E), the content thereof is preferably 10 parts by weight to 150 parts by weight, and more preferably 30 parts by weight to 120 parts by weight, based on a value of 100 parts by weight for the total amount of cyanate ester compound (B) and epoxy resin (C) from the viewpoint of moldability. In particular, in the case a component (D) to be subsequently described is present in the resin composition of the present invention, the amount of the silica (E) is normally preferably 10 parts by weigh to 150 parts by weight, and particularly preferably 30 parts by weight to 120 parts by weight, based on a value of 100 parts by weight for the total amount of components (B) to (D).

A silane coupling agent or dispersing agent can also be used in combination with the aforementioned silica (E).

There are no particular limitations on the silane coupling agent provided it is a silane coupling agent typically used in surface treatment of inorganic materials. Specific examples thereof include aminosilane-based coupling agents such as γ-aminopropyltriethoxysilane or N-β-(aminoethyl)-γ-aminopropyltrimethoxysilane, epoxy silane-based coupling agents such as γ-glycidoxypropyltrimethoxysilane, vinyl silane-based coupling agents such as γ-methacryloxypropyltrimethoxysilane, cationic silane-based coupling agents such as N-β-(N-vinylbenzylaminoethyl)-γ-aminopropyltrimethoxysilane hydrochloride and phenyl silane-based coupling agents, and one type can be used or two or more types can be used in a suitable combination thereof. In the case of using a silane coupling agent, although varying according to the type of silane coupling agent, the amount thereof used is normally preferably within the range of 0.05 parts by weight to 10 parts by weight and particularly preferably within the range of 0.1 parts by weight to 7 parts by weight based on a value of 100 parts by weight for the amount of silica.

There are no particular limitations on the dispersing agent provided it is a dispersion stabilizer used for coating materials. Examples thereof include dispersing agents such as Disperbyk-110, 180, 161, BYK-W996, W9010 and W903 manufactured by Byk Chemie Japan K.K. Any one type of these dispersing agents may be used alone or two or more types may be concurrently used in an arbitrary combination and ratio. In the case of using a dispersing agent, although varying according to the type of dispersing agent, the amount used is normally preferably within the range of 0.05 parts by weight to 10 parts by weight and particularly preferably within the range of 0.1 part by weight to 7 parts by weight based on a value of 100 parts by weight for the amount of silica.

The resin composition of the present invention may contain the aforementioned components (A) to (D), as well as one or two or more other components in addition to the optionally incorporated component (E).

For example, a curing accelerator can also be concurrently used in the resin composition of the present invention as necessary in order to suitably adjust the curing rate. There are no particular limitations the curing accelerator provided it is known and commonly used as a curing accelerator of cyanate ester compounds and epoxy resins. Specific examples thereof include organic metal salts such as those of copper, zinc, cobalt or nickel (such as zinc octylate or manganese octylate), imidazoles and derivatives thereof (such as triphenylimidazole or 2-ethyl-4-methylimidazole), and tertiary amines. Any one type of these curing accelerators may be used alone or two or more types may be used concurrently in an arbitrary combination and ratio. In the case of using a curing accelerator, although varying according to the type of curing accelerator, the amount used is normally preferably within the range of 0.01 part by weight to 2 parts by weight, and particularly preferably within the range of 0.1 part by weight to 1 part by weight, based on a value of 100 parts by weight for the total amount of components (B) and (C).

Additional components can also be used concurrently in the resin composition of the present invention within a range that does not impair the expected properties thereof, examples of which include other thermosetting resins, thermoplastic resins and oligomers thereof, various polymer compounds such as elastomers, and other incombustible compounds and additives. There are no particular limitations on these various types of additional components provided they are commonly used components. For example, examples of incombustible compounds include phosphate esters, melamine phosphate, phosphorous-containing epoxy resins, nitrogen compounds such as melamine or benzoguanamine, oxazine ring-containing compounds and silicon-based compounds. Additives such as ultraviolet absorbers, antioxidants, photopolymerization initiators, fluorescent brightening agents, photosensitizers, dyes, pigments, thickeners, lubricants, antifoaming agents, dispersing agents, leveling agents or optical brighteners can be used as desired by suitably combining. Any one type of these additional components may be used alone or two or more types may be used concurrently in an arbitrary combination and ratio.

The resin composition of the present invention is prepared by mixing the aforementioned components, namely the acid-soluble inorganic filler (A), cyanate ester compound (B) and epoxy resin (C), along with the bismaleimide (D) and silica (E) as necessary, as well as other components. The resin composition of the present invention can also be used as a solution of a resin composition dissolved in an organic solvent as necessary. There are no particular limitations on the organic solvent provided it dissolves each of the aforementioned components. Specific examples thereof include ketones such as acetone, methyl ethyl ketone or methyl isobutyl ketone, polar solvents such as dimethylacetoamide or dimethylformamide, and aromatic hydrocarbon solvents such as toluene or xylene, and these are used alone or two or more types are used by mixing.

### [Prepreg]

According to another aspect of the present invention, a prepreg is provided that comprises a substrate and an insulated layer composed of the resin composition of the present invention laminated on the substrate.

A known substrate used in various types of printed wiring board materials can be used for the substrate used when producing a prepreg of the present invention. Examples of substrates include inorganic fibers such as those composed of E glass, D-glass, S-glass, T-glass, NE-glass or quartz, and organic fibers such as polyamide or liquid crystal polyester fibers, and the substrate can be suitably selected according to the target application and performance level. Examples of the form of the substrate include a woven fabric, non-woven fabric, roping, chopped strand mat and surfacing mat. Although there are no particular limitations on the thickness of the substrate, normally the substrate is preferably used in laminate sheet applications having a thickness of 0.01 mm to 0.3 mm. Among these, glass fibers are preferable in terms of strength, water repellency and moisture absorption heat resistance, while liquid crystal polyester woven fabric is preferable in terms of electrical properties. A woven fabric that has undergone ultra-opening treatment or blocking treatment is particularly preferable in terms of dimensional stability. In addition, a glass woven fabric subjected to surface treatment with a silane coupling agent in the form of epoxy silane treatment or aminosilane treatment is preferable in terms of moisture absorption heat resistance.

There are no particular limitations on the method used to produce the prepreg of the present invention provided it allows the production of a prepreg by combining the aforementioned resin composition and a substrate. A specific example of a method for producing the prepreg consists of impregnating or coating the resin composition of the present invention on a substrate, and semi-curing by heating for 1 minute to 60 minutes in a dryer at 100°C to 200°C. The amount of resin composition adhered to the substrate is preferably within the range of 20% by weight to 95% by weight based on the amount of resin of the prepreg (including the inorganic filler).

The prepreg of the present invention can be used as a buildup material of a printed wiring board. Here, buildup refers to fabricating a printed wiring board having a multilayer structure by laminating a prepreg or resin sheet, and repeating hole drilling and wire forming for each layer. The prepreg of the present invention (substrate and resin composition of the present invention adhered thereto) composes an insulated layer in a printed wiring board formed by using the prepreg of the present invention. Furthermore, the printed wiring board will be subsequently described.

### [Resin Sheet]

According to another aspect of the present invention, a resin sheet is provided comprising an outer layer composed of a metal foil or film, and an insulated layer composed of the resin composition of the present invention laminated on the outer layer.

Although there are no particular limitations on the metal foil or metal film used for the outer layer, examples thereof include a foil or film composed of a metal such as copper or aluminum. In particular, a copper foil or copper film is preferable, while an electrolytic copper foil, rolled copper foil or copper alloy film and the like can be used particularly preferably. The metal foil or metal film may be subjected to known surface treatment such as nickel treatment or cobalt treatment. Although the thickness of the metal foil or metal film can be suitably adjusted according to the application in which it is used, it is preferably within the range of, for example, 5 µm to 70 µm.

The resin sheet of the present invention can be produced by a method known among persons with ordinary skill in the art, an example of which consists of preparing a resin varnish obtained by dissolving the resin composition of the present invention in an organic solvent, coating this resin varnish onto the aforementioned metal foil or metal film serving as a support, and heating or blowing with hot air to dry the organic solvent and form a resin composition layer.

Although there are no particular limitations on the drying conditions, drying is carried out so that the content ratio of the organic solvent in the resin composition is normally 10 parts by weight or less and preferably 5 parts by weight or less. Although varying according to the amount of organic solvent in the varnish, in the case of varnish containing 30 parts by weight to 60 parts by weight of organic solvent, for example, drying is carried out for about 3 minutes to 10 minutes at 50°C to 150°C.

The thickness of the resin composition layer formed in the resin sheet is normally equal to or greater than the thickness of the conductor layer possessed by the printed circuit board fabricated using the resin sheet. Since the thickness of the conductor layer of the circuit board is normally within the range of 5 µm to 70 µm in the same manner as the aforementioned metal foil or metal film, the thickness of the resin composition layer is preferably 10 µm to 100 µm.

The resin sheet of the present invention can also be used as a buildup material of a printed wiring board. In a printed wiring board formed using the resin sheet of the present invention, the layer composed of the resin composition of the present invention composes an insulated layer. The printing wiring board will be subsequently described.

### [Metal Foil-Clad Laminate Sheet]

According to another aspect of the present invention, a metal foil-clad laminate sheet is provided containing the prepreg of the present invention and a metal foil laminated on one side or both sides of the prepreg. One prepreg or two or more sheets of prepregs of the present invention may be laminated.

The metal foil-clad laminate sheet of the present invention is produced by superimposing one or a plurality of the aforementioned prepregs, arranging a metal foil on one side or both sides of the surface of an insulated layer, and lamination molding under conditions of, for example, a temperature of 180°C to 220°C, heating time of 100 minutes to 300 minutes, and contact pressure of 20 kgf/cm² to 40 kgf/cm² (approximately 2 N/mm² to 3.9 N/mm²). Although there are no particular limitations on the thickness of the metal foil used provided it is that used in printed wiring board materials, it is preferably 3 µm to 35 µm.

In addition, the surface roughness (Rz) of the matte surface of the metal foil is normally preferably 1.5 µm to 2.5 µm from the viewpoint of being able to transfer the matte surface of the metal foil to the surface of the insulated layer and enhancing adhesion with a plated conductor layer formed on the insulated layer due to anchoring effects of the surface irregularities transferred to the insulated layer surface. In addition, as will be subsequently described, the surface roughness (Rz) of the insulated layer surface to which surface irregularities are transferred from the metal foil matte surface is normally preferably equal to or less than 5 µm and particularly preferably equal to or less than 3 µm. Here, surface roughness (Rz) refers to an indicator that represents the surface roughness of the metal foil matte surface or insulating layer, and is represented by measuring a roughness curve of a target measured surface with a laser microscope, respectively extracting five peaks that exceed the mean line in ascending order and five troughs that do not reach the mean line in descending order, and calculating the average of the absolute values of the extracted peak heights and trough depths.

The metal foil-clad laminate sheet of the present invention can also be used as a buildup material of a printed wiring board. In a printed wiring board formed using the metal foil-clad laminate sheet of the present invention, the prepreg of the present invention (substrate and resin composition of the present invention adhered thereto) composes an insulated layer. The printed wiring board is described below.

### [Printed Wiring Board]

According to another aspect of the present invention, a printed wiring board is provided that comprises an insulated layer and a conductor layer formed on the surface of the insulated layer, wherein the insulated layer contains the aforementioned resin composition of the present invention.

This printed wiring board can be fabricated using the aforementioned prepreg, resin sheet or metal foil-clad laminate sheet of the present invention as a buildup material. As a result, the resin composition of the prepreg of the present invention (substrate and resin composition of present invention adhered thereto) or resin sheet of the present invention (layer composed of the resin composition of the present invention) composes an insulated layer containing the resin composition of the present invention. Here, buildup refers to the task of fabricating a printed wiring board by repeating hole drilling and wire forming for each layer on the prepreg, resin sheet or metal foil-clad laminate sheet.

In the case of using the prepreg or resin sheet of the present invention as a buildup material, the printed wiring board of the present invention is obtained by, for example, subjecting the resin composition (insulated layer) of the prepreg or resin sheet to surface treatment in accordance with ordinary methods, and forming a wiring pattern (conductor layer) by plating on the insulated layer surface.

In addition, in the case of using the metal foil-clad laminated sheet of the present invention as a buildup material, the printed wiring board of the present invention is obtained by, for example, etching the metal foil of the metal foil-clad laminate sheet in accordance with ordinary methods, surface-treating the resin composition (insulated layer) in accordance with ordinary methods, and forming a wiring pattern (conductor layer) by plating on the insulated layer surface.

The following provides an explanation of each step for producing the printed wiring board of the present invention.

Hole drilling processing is carried out in order to form via holes, through holes and the like. Hole drilling processing is carried out using any type of known method such as the use of an NC drill, carbon dioxide laser, UV laser, YAG laser or plasma, or two or more types of these methods are combined as necessary.

Although the surface of the insulated layer is subsequently plated, from the viewpoints of adhesiveness of the plating and smear removal, the insulated layer is preferably subjected to surface treatment. Although examples of surface treatment include roughening treatment and silane coupling treatment, roughening treatment in particular is carried out from the viewpoint of enhancing plating adhesiveness. In this case, since the roughened state varies according to differences in the degree of curing of the resin composition, the conditions for lamination molding are optimally selected in combination with subsequent roughening treatment conditions and plating conditions.

Next, a detailed explanation is provided regarding the aforementioned roughening treatment. This step also serves as a step for removal of smears caused by hole drilling processing. Roughening treatment is composed of a surface insulated layer swelling step using a swelling agent in order to improve wettability, surface roughening and smear dissolving step using an oxidant, and neutralizing step using a reductant.

The swelling agent used in the swelling step is only required to be able to improve wettability of the surface insulated layer and cause swelling to a degree that allows oxidative degradation to proceed in the subsequent roughening step, and for example, an alkaline solution or surfactant solution is used.

A permanganate solution is used for the oxidant in the surface roughening and smear dissolving step using an oxidant. In addition to these methods referred to as wet desmear methods, known roughening treatment can be used in combination therewith, examples of which include dry desmearing by plasma treatment or UV treatment, mechanical polishing such as buffing, and sandblasting. Specific examples of permanganate solutions include aqueous potassium permanganate solution and aqueous sodium permanganate solution.

An amine-based reductant can be used for the reductant used in the neutralizing step, and examples thereof include acidic reductants such as aqueous hydroxylamine sulfate solution, aqueous ethylenediamine tetraacetate solution or aqueous nitrilotriacetate solution.

In terms of forming hyperfine wiring, the surface irregularities formed following roughening treatment are preferably as small as possible. More specifically, the surface irregularities preferably have an Rz value of equal to or less than 5 µm and more preferably equal to or less than 3 µm. Since surface irregularities formed following roughening treatment are determined according to the degree of curing of the resin composition and roughening treatment conditions, it is preferable to select the optimum conditions for obtaining the desired surface irregularities.

Next, a detailed explanation is provided regarding the plating step carried out following roughening treatment. Although a known method can be used for the patterning method carried out by plating, and examples thereof include patterning methods such as a semi-additive method, full-additive method and subtractive method after having first formed a conductor layer by plating, a semi-additive method is preferable for forming hyperfine wiring.

Patterning by plating preferably consists of carrying out drying after plating in order to increase adhesive strength by drying after plating. In the case of patterning using a semi-additive method, although non-electrolytic plating and electrolytic plating are carried out in combination, at that time drying is preferably carried out after non-electrolytic plating and electrolytic plating, respectively. Drying after non-electrolytic plating is preferably carried out for 10 minutes to 120 minutes at 80°C to 180°C, while drying after electrolytic plating is preferably carried out for 10 minutes to 120 minutes at 130°C to 220°C.

The printed wiring board of the present invention can also be used in the form of a multilayer printed wiring board. For example, after having formed the metal foil-clad laminate sheet of the present invention, having metal foil (such as copper or aluminum foil) arranged on both sides of the prepreg of the present invention, according to the aforementioned procedure, an inner layer circuit is formed therein and black oxide treatment is carried out on the resulting circuit to form an inner layer circuit board. A multilayer printed wiring board is produced by lamination molding by repeating a procedure consisting of arranging the prepreg or resin sheet of the present invention on one side or both sides of the inner layer circuit board obtained in this manner or a metal foil (such as copper foil or aluminum foil), and further arranging a metal foil (such as copper foil or aluminum foil) or a release film (film obtained by coating a mold release agent on the surface of a polyethylene film, polypropylene film, polycarbonate film, polyethylene terephthalate film or ethylene-tetrafluoroethylene copolymer film and the like) on the outside thereof, followed by suitably carrying out various types of affirmation as described above.

A commonly used technique such as the use of a multistage press, laminator, vacuum laminator or autoclave molding machine used in lamination molding of ordinary laminate sheets for printed wiring boards is used for lamination molding, and is carried out by suitably selecting the temperature to be within the range of, for example, 100°C to 300°C, the pressure to be within the range of, for example, 0.1 kgf/cm² to 100 kgf/cm² (about 9.8 kPa to 38 MPa), and the heating time to be within the range of, for example, 30 seconds to 5 hours. In addition, post-curing may be carried out as necessary at a temperature of, for example, 150°C to 300°C to adjust the degree of curing.

### EXAMPLES

Although the following provides a detailed explanation of the present invention by indicating synthesis examples, examples and comparative examples thereof, the present invention is not limited thereto. Furthermore, in the following descriptions, the term "parts" refers to parts by weight unless specifically indicated otherwise.

### Synthesis Example 1 - Synthesis of α-Naphthol Aralkyl-Type

### Cyanate Ester Compound (Formula (1a))

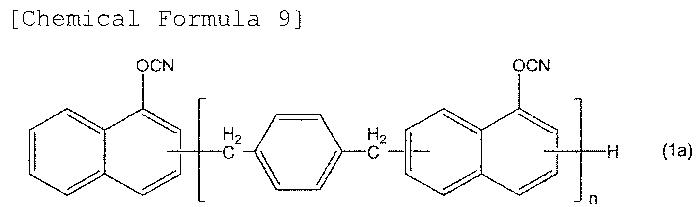

A reactor equipped with a thermometer, stirrer, dropping funnel and reflux condenser was preliminarily cooled to 0°C to 5°C with brine and then charged with 7.47 g (0.122 mol) of cyanogen chloride, 9.75 g (0.0935 mol) of 35% hydrochloric acid, 76 ml of water and 44 ml of methylene chloride. While holding the temperature inside the reactor to -5°C to +5°C and the pH to 1 or lower, 20 g (0.0935 mol) of the α-naphthol aralkyl resin represented by formula (1a') (SN485, OH equivalent: 214 g/eq, softening point: 86°C, Nippon Steel Chemical Co., Ltd.) and a solution obtained by dissolving 14.16 g (0.14 mol) of triethylamine in 92 ml of methylene chloride were respectively dropped in over the course of 1 hour with the dropping funnel while stirring.

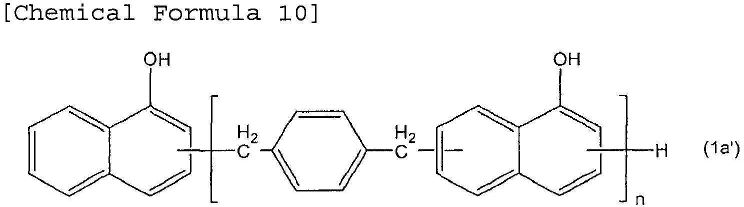

Following completion of dropping, 4.72 g (0.047 mol) of triethylamine were additionally dropped in over the course of 15 minutes. Following completion of dropping, the reaction liquid was separated after stirring for 15 minutes at the same temperature followed by removal of the organic layer. After washing the resulting organic layer twice with 100 ml of water, the methylene chloride was distilled off under reduced pressure with an evaporator followed by concentrating and drying to a solid for 1 hour at 80°C to obtain 23.5 g of a cyanate ester compound of the α-naphthol aralkyl resin represented by the aforementioned formula (1a) (α-naphthol aralkyl-type cyanate ester compound). The weight average molecular weight (Mw) of the compound of formula (1a) as measured by GPC was 856.

### Reference Example 1

70 parts of magnesium oxide (average particle diameter: 0.4 µm, FNM-G, Tateho Chemical Industries Co., Ltd.) was used for the acid-soluble inorganic filler (A), 60 parts of the α-naphthol aralkyl-type cyanate ester compound obtained according to Synthesis Example 1 (cyanate equivalent: 237 g/eq) was used for the cyanate ester compound (B), and 35 parts of the phenol biphenyl aralkyl-type epoxy resin represented by the aforementioned formula (4) (NC-3000-FH, epoxy equivalent: 320 g/eq, n in formula (4) = 6 to 10, Nippon Kayaku Co., Ltd.) and 5 parts of the naphthalene tetrafunctional epoxy resin represented by the aforementioned formula (5) (EXA4710, epoxy equivalent: 170 g/eq, Dainippon Ink and Chemicals, Inc.) were used for the epoxy resin (C). These components were mixed and dissolved in methyl ethyl ketone followed by mixing in 0.2 parts of zinc octylate to obtain a varnish (resin composition solution). This varnish was then diluted with methyl ethyl ketone and impregnated and coated onto an E-glass woven fabric having a thickness of 0.1 mm followed by heating and drying for 4 minutes at 160°C to obtain a prepreg having a resin content of 50% by weight. Four sheets of the resulting prepreg were superimposed and arranged on the resin layer side of a matte surface of electrolytic copper foil having a thickness of 12 µm (F1-WS, Furukawa Electric Co., Ltd.) followed by carrying out lamination molding for 120 minutes at a pressure of 30 kgf/cm² (approx. 2.9 N/mm²) and temperature of 120°C to obtain a copper-clad laminate sheet having a resin insulated layer thickness of 0.4 mm.

### Example 2

A copper-clad laminate sheet was obtained in the same manner as Reference Example 1 with the exception of preparing the varnish using 45 parts of the α-naphthol aralkyl-type cyanate ester compound of formula (1a), using 30 parts of the phenol biphenyl aralkyl-type epoxy resin of formula (4), and further using 20 parts of bis(3-ethyl-5-methyl-4-maleimidophenyl)methane (BMI-70, K-I Chemical Industry Co., Ltd.) as bismaleimide (D).

### Example 3

A copper-clad laminate sheet was obtained in the same manner as Example 2 with the exception of preparing the varnish by changing the 45 parts of the α-naphthol aralkyl-type cyanate ester compound of formula (1a) to 45 parts of a novolac-type cyanate ester compound in which all R in the aforementioned formula (2) are hydrogen atoms (PT-30, number average molecular weight (Mn): 615, Lonza Inc.) for use as cyanate ester compound (B).

### Example 4

A copper-clad laminate sheet was obtained in the same manner as Example 2 with the exception of preparing the varnish by changing the 45 parts of the α-naphthol aralkyl-type cyanate ester compound of formula (1a) to 45 parts of a bisphenol A-type dicyanate in which all R in the aforementioned formula (3) are hydrogen atoms (BPA-CN, number average molecular weight (Mn): 1570, Mitsubishi Gas Chemical Co., Inc.) for use as cyanate ester compound (B).

### Example 5

A copper-clad laminate sheet was obtained in the same manner as Example 2 with the exception of preparing the varnish by changing the amount of the phenol biphenyl aralkyl-type epoxy resin of formula (4) to 15 parts, and changing the amount of the naphthalene tetrafunctional epoxy resin of formula (5) to 20 parts.

### Example 6

A copper-clad laminate sheet was obtained in the same manner as Example 2 with the exception of preparing the varnish using 45 parts of the aromatic hydrocarbon-formaldehyde-type epoxy resin represented by the aforementioned formula (6) (YX7700, epoxy equivalent: 270 g/eq, softening point: 64°C, melt viscosity: 2.2 Pa·s/150°C, Mitsubishi Chemical Corp.) instead of 45 parts of the phenol biphenyl aralkyl-type epoxy resin of formula (4) for the epoxy resin (C).

### Reference Example 7

A copper-clad laminate sheet was obtained in the same manner as Example 2 with the exception of preparing the varnish by using 70 parts of magnesium hydroxide (average particle diameter: 2.0 µm, MGZ-6R, Sakai Chemical Industry Co., Ltd.) instead of 70 parts of magnesium oxide (FNM-G) for the acid-soluble inorganic filler (A).

### Example 8

A copper-clad laminate sheet was obtained in the same manner as Example 2 with the exception of preparing the varnish by using 70 parts of magnesium oxide (average particle diameter: 0.1 µm, SMO-0.1, Sakai Chemical Industry Co., Ltd.) subjected to silane coupling treatment over 2% of the surface area thereof using 3-glycidoxypropyltrimethoxysilane (KBM-403, Shin-Etsu Chemical Co., Ltd.) instead of 70 parts of magnesium oxide (FNM-G) for the acid-soluble inorganic filler (A).

### Example 9

A copper-clad laminate sheet was obtained in the same manner as Example 2 with the exception of preparing the varnish using 70 parts of magnesium oxide (average particle diameter: 0.4 µm, SMO-0.4, Sakai Chemical Industry Co., Ltd.) subjected to silane coupling treatment over 2% of the surface area thereof using 3-glycidoxypropyltrimethoxysilane (KBM-403, Shin-Etsu Chemical Co., Ltd.) instead of 70 parts of magnesium oxide (FNM-G) for the acid-soluble inorganic filler (A).

### Reference Example 10

A copper-clad laminate sheet was obtained in the same manner as Example 2 with the exception of preparing the varnish using 70 parts of magnesium oxide (average particle diameter: 2.0 µm, SMO, Sakai Chemical Industry Co., Ltd.) subjected to silane coupling treatment over 2% of the surface area thereof using 3-glycidoxypropyltrimethoxysilane (KBM-403, Shin-Etsu Chemical Co., Ltd.) instead of 70 parts of magnesium oxide (FNM-G) for the acid-soluble inorganic filler (A).

### Example 11

A copper-clad laminate sheet was obtained in the same manner as Example 2 with the exception of preparing the varnish by using 35 parts of magnesium oxide (FNM-G) for the acid-soluble inorganic filler (A), and further adding 35 parts of silica (average particle diameter: 0.7 µm, SFP-130MC, Denki Kagaku Kogyo K.K.).

### Comparative Example 1

A copper-clad laminate sheet was obtained in the same manner as Example 2 with the exception of preparing the varnish without using an acid-soluble inorganic filler (A) in the form of 70 parts of magnesium oxide (FNM-G).

### Comparative Example 2

A copper-clad laminate sheet was obtained in the same manner as Example 2 with the exception of preparing the varnish without using an acid-soluble inorganic filler (A) in the form of 70 parts of magnesium oxide (FNM-G), and instead using 70 parts of boehmite (Apyral AOH60, Nabaltec AG).

### Comparative Example 3

A copper-clad laminate sheet was obtained in the same manner as Example 2 with the exception of preparing the varnish without using an acid-soluble inorganic filler (A) in the form of 70 parts of magnesium oxide (FNM-G), and instead using 70 parts of silica (SFP-130MC, Denki Kagaku Kogyo K.K.).

### Comparative Example 4

A copper-clad laminate sheet was obtained in the same manner as Example 2 with the exception of preparing the varnish without using a cyanate ester compound (B) in the form of the α-naphthol aralkyl-type cyanate ester compound of formula (1a), and instead using 45 parts of bisphenol A (BPA, Mitsubishi Chemical Corp.).

### Comparative Example 5

A copper-clad laminate sheet was obtained in the same manner as Example 2 with the exception of preparing the varnish without using a cyanate ester compound (B) in the form of the α-naphthol aralkyl-type cyanate ester of formula (1a), and instead using 45 parts of naphthol aralkyl-type phenol resin (SN495V2(SN-OH), Nippon Steel Chemical Co., Ltd.), and further using an imidazole (Curezol 2E4MZ-CNS, Shikoku Chemicals Corp.) as a curing accelerator.

### Wet Roughening Treatment and Conductor Layer Plating

The surface layer copper foil of the copper-clad laminate sheets obtained in Examples 1 to 11 and Comparative Examples 1 to 5 was removed by etching, followed by immersing for 5 minutes at 60°C in a swelling treatment solution manufactured by Okuno Chemical Industries (OPC-B103 Pre-Etch: 400 ml/L, sodium hydroxide: 13 g/L). Next, the laminate sheets were immersed for 25 minutes at 80°C in a roughening treatment solution manufactured by Okuno Chemical Industries (OPC-1540NM: 100 ml/L, OPC-1200 Epoetch: 100 ml/L). Finally, the laminate sheets were subjected to desmear treatment by immersing for 5 minutes at 45°C in a neutralizing treatment solution manufactured by Okuno Chemical Industries (OPC-1300 Neutralizer: 200 ml/L). Subsequently, the laminate sheets were subjected to non-electrolytic plating at about 0.5 µm by a non-electrolytic copper plating process manufactured by Okuno Chemical Industries (reagents used: OPC-370 Condiclean M, OPC-SAL M, OPC-80 Catalyst, OPC-555 Accelerator M, ATS Adcopper IW) followed by drying for 1 hour at 130°C. Continuing, electrolytic copper plating was carried out until the thickness of the copper plating reached 20 µm followed by drying for 1 hour at 180°C. Thus, circuit wiring board samples were fabricated having a conductor layer (plated copper) of a thickness of about 20 µm formed on a resin insulated layer having a thickness of 0.4 mm, and these samples were subjected to the evaluations indicated below.

### Measurement Methods

### 1) Plated Copper Adhesive Strength

Adhesive strength of the plated copper was measured three times in compliance with JIS C6481 using the circuit wiring board samples fabricated according to the aforementioned procedure followed by determining the average value thereof. Evaluations were carried out on those portions that had not blistered for those samples that exhibited blistering during drying following electrolytic copper plating. The results are shown in Tables 1 to 3.

### 2) Moisture Absorption Heat Resistance

After cutting the circuit wiring board samples fabricated according to the aforementioned procedure into squares measuring 50 mm x 50 mm, the plated copper was removed by etching with the exception of half of one side to prepare samples. The samples were treated for 1, 3 or 5 hours at 121°C and 2 atm with a pressure cooker tester (Model PC-3, Hirayama Seisakusho K.K.), followed by immersing for 30 seconds in a soldering pot at 260°C and visually observing for the presence or absence of abnormal changes in appearance. Testing was carried out three times and samples free of abnormalities were indicated with "OK", while samples in which blistering had occurred were indicated with "NG". The results are shown in Tables 1 to 3. Furthermore, "PCT-1H", "PCT-3H" and "PCT-5H" in the table respectively refer to results obtained after treating with the pressure cooker tester for 1, 3 and 5 hours.

### 3) Surface Roughness

The surface layer copper foil of the circuit wiring board samples prepared according to the aforementioned procedure was removed by etching followed by determination of surface roughness Rz (average roughness of 10 locations) of the insulated layer surface based on images magnified by a factor of 3000 using a laser microscope (Model VK-9500, Keyence Corp.). The results are shown in Tables 1 to 3.

### 4) Coefficient of Linear Expansion

The surface layer copper foil of the copper-clad laminate sheets fabricated in Examples 2 and 11 was removed by etching, followed by measuring coefficient of linear expansion in the planar direction from 60°C to 120°C by raising the temperature from 40°C to 340°C with a thermomechanical analyzer (TA Instruments, Inc.). The vertical direction (X) from the surface of the glass cloth was used for the measuring direction. The results are shown in Table 4.

### Results

**[Table 1]**

| Table 1 | | Ref. Ex.1 | Ex.2 | Ex.3 | Ex.4 | Ex.5 | Ex.6 |
|---|---|---|---|---|---|---|---|
| Plated copper peel strength (kg/cm²) | | 0.67 | 0.65 | 0.61 | 0.58 | 0.61 | 0.63 |
| Surface roughness Rz (µm) | | 2.74 | 1.51 | 2.00 | 2.24 | 1.80 | 1.95 |
| Moisture absorption heat resistance | PCT-1H | OK OK OK | OK OK OK | OK OK OK | OK OK OK | OK OK OK | OK OK OK |
| | PCT-3H | OK OK OK | OK OK OK | OK OK OK | OK OK OK | OK OK OK | OK OK OK |
| | PCT-5H | NG NG NG | OK OK OK | OK OK OK | NG NG NG | OK OK OK | OK OK OK |
| Glass transition temperature (°C) | | 245.3 | 254.8 | 246.3 | 231.4 | 251.3 | 253.2 |

**[Table 2]**

| Table 2 | | Ref. Ex.7 | Ex. 8 | Ex.9 | Ref. Ex.10 | Ex.11 |
|---|---|---|---|---|---|---|
| Plated copper peel strength (kg/cm²) | | 0.25 | 0.59 | 0.65 | 0.61 | 0.63 |
| Surface roughness Rz (µm) | | 2.90 | 2.50 | 2.60 | 3.80 | 2.30 |
| Moisture absorption heat resistance | PCT-1H | OK OK OK | OK OK OK | OK OK OK | OK OK OK | OK OK OK |
| | PCT-3H | OK OK OK | OK OK OK | OK OK OK | OK OK OK | OK OK OK |
| | PCT-5H | OK OK OK | OK OK OK | OK OK OK | NG NG NG | OK OK OK |
| Glass transition temperature (°C) | | 252.2 | 251.8 | 252.9 | 253.8 | 254.9 |

**[Table 3]**

| Table 3 | | Comp.Ex.1 | Comp.Ex.2 | Comp.Ex.3 | Comp.Ex.4 | Comp.Ex.5 |
|---|---|---|---|---|---|---|
| Plated copper peel strength (kg/cm²) | | 0.25 | 0.10 | 0.20 | 0.38 | 0.57 |
| Surface roughness Rz (urn) | | 2.18 | 1.80 | 1.80 | 3.37 | 3.50 |
| Moisture absorption heat resistance | PCT-1H | NG NG NG | OK OK OK | NG NG NG | NG NG NG | OK OK OK |
| | PCT-3H | NG NG NG | NG NG NG | NG NG NG | NG NG NG | NG NG NG |
| | PCT-5H | NG NG NG | NG NG NG | NG NG NG | NG NG NG | NG NG NG |
| Glass transition temperature (°C) | | 252.2 | 251.6 | 253.9 | 215.7 | 229.2 |

**[Table 4]**

| Table 4 | Example 2 | Example 11 |
|---|---|---|
| Coefficient of linear expansion (ppm/°C) | 19.7 | 16.8 |

According to Tables 1 to 3, Comparative Example 1, in which an acid-soluble inorganic filler (A) is not used, Comparative Examples 2 and 3, in which boehmite and silica are respectively used instead of the acid-soluble inorganic filler (A), Comparative Example 4, in which bisphenol A is used instead of the cyanate ester compound (B), and Comparative Example 5, in which a phenol resin is used instead of cyanate ester compound (B), all demonstrated high surface roughness and plating peel strength was inferior in comparison to that of the examples. In addition, Examples 2-6, 8, 9 and 11 and Reference Examples 1, 7 and 10 were confirmed to be superior to Comparative Examples 1 to 5 with respect to moisture absorption heat resistance of the insulated layer as well.

### INDUSTRIAL APPLICABILITY

As has been previously described, in the case of using as a material of an insulated layer of a printed wiring board, the resin composition of the present invention allows the formation of a roughened surface having a low degree of roughness on the surface of an insulated layer irrespective of roughening conditions, and demonstrates various effects such as being superior with respect to adhesiveness of the conductor layer formed on the roughened surface, heat resistance, moisture absorption heat resistance, thermal expansion and chemical resistance. Accordingly, the resin composition of the present invention is extremely useful as a material of an insulated layer of a printed wiring board, and the industrial practicality thereof is extremely high.

## Claims

1. A resin composition comprising: an acid-soluble inorganic filler (A); a cyanate ester compound (B); an epoxy resin (C); and a bismaleimide (D);
wherein the acid-soluble inorganic filler (A) is magnesium oxide and has an average particle diameter of between 0.1 and 1.0 µm.

2. The resin composition according to claim 1, wherein the cyanate ester compound (B) is at least one compound selected from the group consisting of:
a naphthol aralkyl-type cyanate ester represented by formula (1): 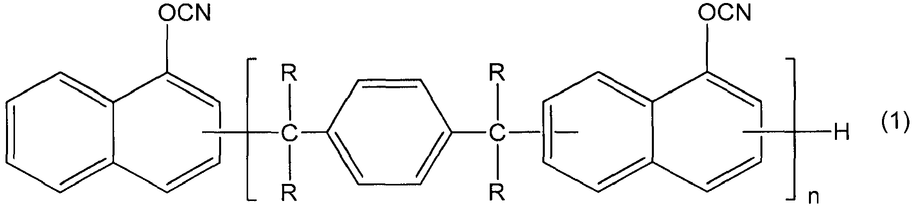 where R is, independently of each other, a hydrogen atom or a methyl group, and n is an integer equal to or larger than 1;
a novolak-type cyanate ester represented by formula (2): 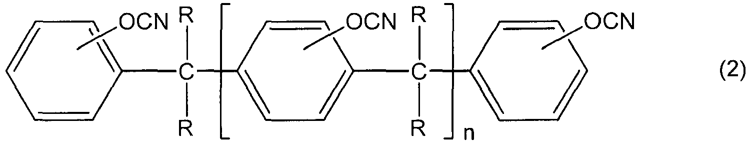 where R is, independently of each other, a hydrogen atom or a methyl group, and n is an integer equal to or larger than 0; and
a biphenyl aralkyl-type cyanate ester represented by formula (3): 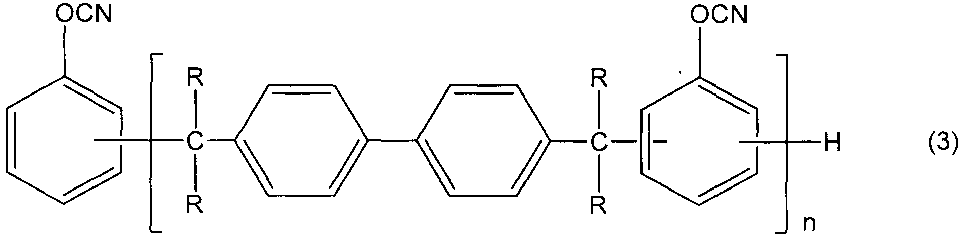 where R is, independently of each other, a hydrogen atom or a methyl group, and n is an integer equal to or larger than 1.

3. The resin composition according to claim 1 or 2, wherein the epoxy resin (C) is at least one selected from the group consisting of phenol biphenyl aralkyl-type epoxy resins, naphthalene tetrafunctional epoxy resins and aromatic-type epoxy resins.

4. The resin composition according to any one of claims 1 to 3, comprising 5 to 100 mass parts of the acid-soluble inorganic filler (A) per 100 mass parts of components (B) and (C) in total.

5. The resin composition according to any one of claims 1 to 4, comprising 10 to 90 mass parts of the cyanate ester compound (B) per 100 mass parts of components (B) and (C) in total.

6. The resin composition according to any one of claims 1 to 5, further comprising a silica (E).

7. The resin composition according to claim 6, comprising 10 to 150 mass parts of the silica (E) per 100 mass parts of the cyanate ester compound resin (B) and the epoxy resin (C) in total.

8. A prepreg comprising: a substrate; and a resin composition according to any one of claims 1 to 7 applied onto the substrate.

9. A resin sheet comprising: an outer layer made of a metal foil or film; and an insulated layer laminated on the outer layer and made of a resin composition according to any one of claims 1 to 7.

10. A metal-foil laminate sheet comprising: a prepreg according to claim 8; and a metal foil laminated on either side or both sides of the prepreg.

11. The printed-wiring board prepared by a method comprising etching the metal foil of a metal-foil laminate sheet according to claim 10, followed by surface treatment and patterning via plating.

12. The printed-wiring board prepared by a method comprising surface treatment of a resin sheet according to claim 9, followed by patterning via plating.

13. A printed-wiring board comprising: an insulated layer; and a conductor layer formed on a surface of the insulated layer, wherein the insulated layer comprises a resin composition according to any one of claims 1 to 7.

## Patentansprüche

1. Harzzusammensetzung, umfassend: einen säurelöslichen anorganischen Füllstoff (A), eine Cyanatesterverbindung (B); ein Epoxyharz (C) und ein Bismaleimid (D);
worin der säurelösliche anorganische Füllstoff (A) Magnesiumoxid ist und einen mittleren Partikeldurchmesser von zwischen 0,1 und 1,0 µm. aufweist.

2. Harzzusammensetzung gemäß Anspruch 1, worin die Cyanatesterverbindung (B) mindestens eine Verbindung ist, ausgewählt aus der Gruppe, bestehend aus:
einem durch die Formel (1) dargestellten Cyanatester vom Naphtholaralkyl-Typ: 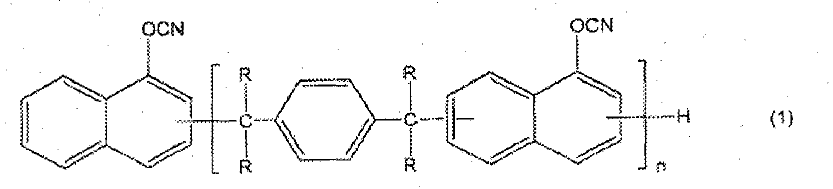 worin R unabhängig voneinander ein Wasserstoffatom oder eine Methylgruppe ist und n eine ganze Zahl ist, die gleich oder größer ist als 1;
einem durch die Formel (2) dargestellter Cyanatester vom Novolak-Typ: 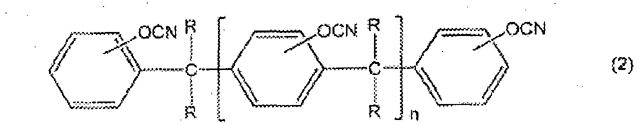 worin R jeweils unabhängig ein Wasserstoffatom oder eine Methylgruppe ist und n eine ganze Zahl ist, die gleich oder größer als 0 ist; und
einem durch die Formel (3) dargestellter Cyanatester vom Biphenylaralkyl-Typ: 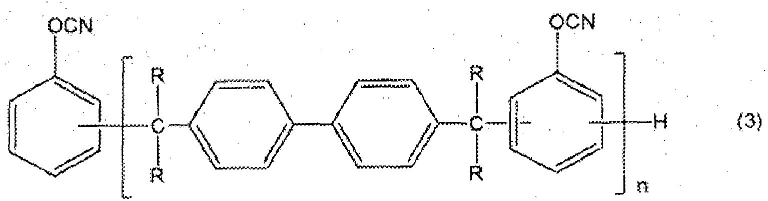 worin R jeweils unabhängig ein Wasserstoffatom oder eine Methylgruppe ist und n eine ganze Zahl ist, die gleich oder größer als 1 ist.

3. Harzzusammensetzung gemäß Anspruch 1 oder 2, worin das Epoxyharz (C) mindestens eines ist, ausgewählt aus der Gruppe, bestehend aus Epoxyharzen vom Phenolbiphenylaralkyl-Typ, tetrafunktionalen Naphthalin-Epoxyharzen und Epoxyharzen vom aromatischen Typ.

4. Harzzusammensetzung gemäß irgendeinem der Ansprüche 1 bis 3, umfassend 5 bis 100 Masseteile des säurelöslichen anorganischen Füllstoffs (A) je 100 Masseteile der Gesamtheit der Komponenten (B) und (C).

5. Harzzusammensetzung gemäß irgendeinem der Ansprüche 1 bis 4, umfassend 10 bis 90 Masseteile der Cyanatesterverbindung (B) je 100 Masseteile der Gesamtheit der Komponenten (B) und (C).

6. Harzzusammensetzung gemäß irgendeinem der Ansprüche 1 bis 5, ferner umfassend ein Silika (C).

7. Harzzusammensetzung gemäß Anspruch 6, umfassend 10 bis 150 Masseteile des Silika (E) je 100 Masseteile der Gesamtheit des Cyanatester-Verbindungsharzes (B) und des Epoxyhazes (C)

8. Prepreg, umfassend: ein Substrat; und eine Harzzusammensetzung gemäß irgendeinem der Ansprüche 1 bis 7, die auf das Substrat aufgetragen ist.

9. Harzblatt, umfassend: eine äußere Schicht, hergestellt aus einer Metallfolie oder einem -film; und eine isolierte Schicht, die auf die äußere Schicht laminiert ist und aus einer Harzzusammensetzung gemäß irgendeinem der Ansprüche 1 bis 7 hergestellt ist.

10. Metallfolienlaminatblatt, umfassend: ein Prepreg gemäß Anspruch 8; und eine Metallfolie, die auf irgendeine Seite oder beide Seiten des Prepregs laminiert ist.

11. Leiterplatine, hergestellt durch ein Verfahren, das das Ätzen der Metallfolie oder eines Metallfolienlaminatblatts gemäß Anspruch 10 umfasst, gefolgt von einer Oberflächenbehandlung und einer Strukturbildung über ein Plattieren.

12. Leiterplatine, hergestellt durch ein Verfahren, das eine Oberflächenbehandlung eines Harzblatts gemäß Anspruch 9 umfasst, gefolgt von Strukturbildung durch Plattieren.

13. Leiterplatine, umfassend: eine isolierte Schicht und eine Leiterschicht, die auf einer Oberfläche der isolierten Schicht gebildet ist, worin die isolierte Schicht eine Harzzusammensetzung gemäß irgendeinem der Ansprüche 1 bis 7 umfasst.

## Revendications

1. Composition de résine comprenant: une charge inorganique soluble dans un acide (A); un composé d'ester de cyanate (B); une résine époxy (C); et un bismaléimide (D);
dans laquelle la charge inorganique soluble dans un acide (A) est un oxyde de magnésium et a un diamètre de particule moyen entre 0,1 et 1,0 µm.

2. Composition de résine selon la revendication 1, dans laquelle le composé d'ester de cyanate (B) est au moins un composé sélectionné dans le groupe constitué :
d'un ester de cyanate de type naphtol aralkyle représenté par la formule (1) : 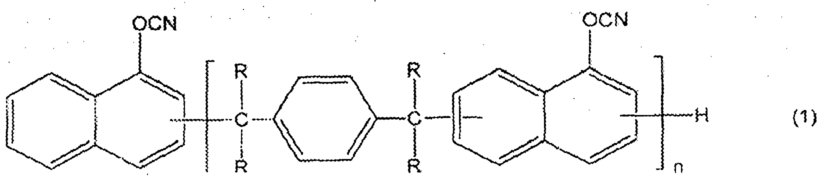 où R est, indépendamment les uns des autres, un atome d'hydrogène ou un groupe méthyle, et n est un entier égal ou supérieur à 1 ; et
d'un ester de cyanate de type novolaque représenté par la formule (2) : 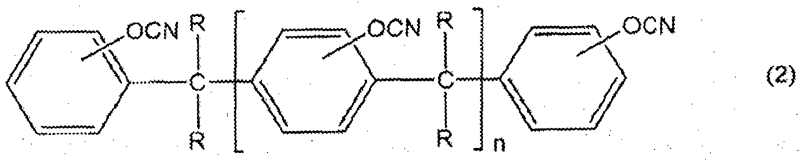 où R est, indépendamment les uns des autres, un atome d'hydrogène ou un groupe méthyle, et n est un entier égal ou supérieur à 0 ; et
d'un ester de cyanate de type biphényle aralkyle représenté par la formule (3) : 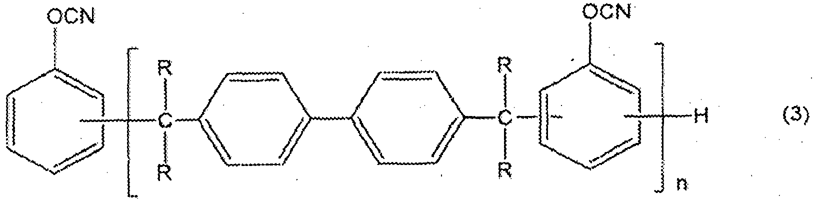 où R est, indépendamment les uns des autres, un atome d'hydrogène ou un groupe méthyle, et n est un entier égal ou supérieur à 1.

3. Composition de résine selon la revendication 1 ou 2, dans laquelle la résine époxy (C) est au moins une sélectionnée dans le groupe constitué de résines époxy de type phénol biphényle aralkyle, de résines époxy tétra-fonctionnelles de naphtalène et de résines époxy de type aromatique.

4. Composition de résine selon l'une quelconque des revendications 1 à 3, comprenant 5 à 100 parties en masse de la charge inorganique soluble dans un acide (A) pour 100 parties en masse de composants (B) et (C) au total.

5. Composition de résine selon l'une quelconque des revendications 1 à 4, comprenant 10 à 90 parties en masse du composé d'ester de cyanate (B) pour 100 parties en masse de composants (B) et (C) au total.

6. Composition de résine selon l'une quelconque des revendications 1 à 5, comprenant en outre une silice (E).

7. Composition de résine selon la revendication 6, comprenant 10 à 150 parties en masse de la silice (E) pour 100 parties en masse de la résine de composé d'ester de cyanate (B) et de la résine époxy (C) au total.

8. Pré-imprégné comprenant : un substrat ; et une composition de résine selon l'une quelconque des revendications 1 à 7 appliquée sur le substrat.

9. Feuille de résine comprenant : une couche externe faite d'une feuille ou d'un film de métal; et une couche isolée stratifiée sur la couche externe et faite d'une composition de résine selon l'une quelconque des revendications 1 à 7.

10. Feuille stratifiée en feuille de métal comprenant : un pré-imprégné selon la revendication 8; et une feuille de métal stratifiée sur l'un ou l'autre ou sur les deux côtés du pré-imprégné.

11. Carte de câblage imprimée préparée par un procédé comprenant la gravure de la feuille de métal d'une feuille stratifiée en feuille de métal selon la revendication 10, suivie d'un traitement de surface et d'un modelage par placage.

12. Carte de câblage imprimée préparée par un procédé comprenant un traitement de surface d'une feuille de résine selon la revendication 9, suivie d'un modelage par placage.

13. Carte de câblage imprimée comprenant: une couche isolée; et une couche conductrice formée sur une surface de la couche isolée, dans laquelle la couche isolée comprend une composition de résine selon l'une quelconque des revendications 1 à 7.
